Europäisches Patentamt

European Patent Office

Office européen des brevets

(11) Veröffentlichungsnummer: **0 400 185**
**A1**

## EUROPÄISCHE PATENTANMELDUNG

(21) Anmeldenummer: **89109872.5**

(22) Anmeldetag: **31.05.89**

(51) Int. Cl.⁵: **G11C 11/24, H01L 27/108**

(43) Veröffentlichungstag der Anmeldung:
**05.12.90 Patentblatt 90/49**

(84) Benannte Vertragsstaaten:
**AT DE FR GB IT NL**

(71) Anmelder: **Siemens Aktiengesellschaft**
**Wittelsbacherplatz 2**
**D-8000 München 2(DE)**

(72) Erfinder: **Utesch, Matthias G.**
**Martinsreutherstrasse 39**
**D-8670 Hof / S.(DE)**

(54) **Integrieter Halbleiterspeicher mit 1-Transistor-Speicherzellen.**

(57) Ein integrierter Halbleiterspeicher mit 1-Transistor-Speicherzellen MC, deren Auswahltransistoren T vertikal oberhalb der Speicherkapazitäten C angeordnet sind, enthält in Vertiefungen Gr wenigstens zwei Speicherzellen MC mit einem den Auswahltransistoren T gemeinsamen Gate G und einer den Speicherkapazitäten C gemeinsamen Elektrode C1.

FIG 4

EP 0 400 185 A1

## Integrierter Halbleiterspeicher mit 1-Transistor-Speicherzellen

Die Erfindung betrifft einen integrierten Halbleiterspeicher mit 1-Transistor-Speicherzellen nach dem Oberbegriff des Patentanspruches 1.

Gattungsgemäße Halbleiterspeicher sind beispielsweise aus der EP-A 0 180 026 und aus der DE-A 35 25 418 bekannt.

Aufgabe der vorliegenden Erfindung ist es, einen gattungsgemäßen Halbleiterspeicher so weiterzubilden, daß die benötigte Grundfläche je Speicherzelle kleiner ist als beim bekannten Halbleiterspeicher und daß die Gefahr des Auftretens von Softfehlern (bekanntlich verursacht durch Alpha-Partikel) mindestens nicht größer wird, nach Möglichkeit jedoch verringert wird. Weiterhin sollen Leckströme bei den Speicherzellen minimal sein.

Diese Aufgabe wird bei einem gattungsgemäßen Halbleiterspeicher gelöst durch die kennzeichnenden Merkmale des Patentanspruches 1. Vorteilhafte Aus- und Weiterbildungen sind in Unteransprüchen gekennzeichnet.

Die Erfindung wird nachstehend anhand von Figuren näher erläutert. Es zeigen, jeweils ausschnittsweise:

Die FIG 1 bis 3 eine Draufsicht auf den Halbleiterspeicher in Höhe seiner Speicherkapazitäten C,

die FIG 4 und 5 Querschnitte durch den Halbleiterspeicher aus verschiedenen Schnittrichtungen,

FIG 6 eine schematische Darstellung der Ausführungsform nach FIG 3,

FIG 7 einen größeren Ausschnitt aus dem erfindungsgemäßen Halbleiterspeicher mit Speicherzellen gemäß FIG 3.

In den FIG dargestellte Schnittlinien sind mit römischen Zahlen bezeichnet. Deren Wert ist gleich der Nummer der FIG, in der die entsprechende Schnittdarstellung erfolgt.

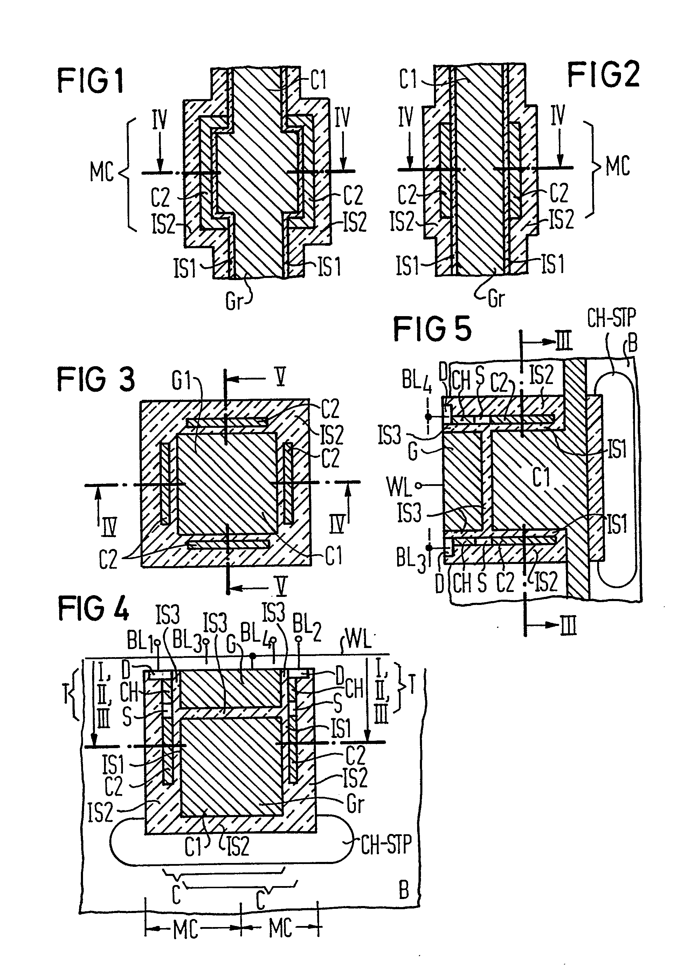

FIG 1 zeigt in Draufsicht einen Ausschnitt aus einem erfindungsgemäßen Halbleiterspeicher, wobei zwei Speicherkapazitäten C von zwei Speicherzellen MC dargestellt sind. Die Schnittebene der Draufsicht ist so gewählt, daß sie unterhalb der zugehörigen Auswahltransistoren T der Speicherzellen MC liegt. Ein zugehöriger Querschnitt durch den Halbleiterspeicher ist, ebenfalls entsprechend ausschnittsweise, in FIG 4 dargestellt. Die Querschnittdarstellung nach FIG 4 ist auch den Darstellungen nach den FIG 2 und 3 zugeordnet.

FIG 1 zeigt ein elektrisch leitendes Material, das in einer grabenförmigen Vertiefung Gr angeordnet ist. Es dient zwei Speicherzellen MC als gemeinsame Elektrode C1 ihrer Speicherkapazitäten C. An beide Seiten des elektrisch leitenden Materials schließen sich erste Isolierschichten IS1 an zur elektrischen Isolation der sonstigen Bestandteile des Halbleiterspeichers von der gemeinsamen Elektrode C1. Im Bereich der Speicherzellen MC schließen sich links und rechts von der gemeinsamen Elektrode C1, jedoch von dieser elektrisch getrennt durch die ersten Isolierschichten IS1, Speicherelektroden C2 der Speicherzellen MC an. Im gezeigten Bereich sind somit zwei Kapazitäten ausgebildet mit einer gemeinsamen Elektrode C1 und mit individuellen Speicherelektroden C2. Diese dienen, wie in FIG 4 gezeigt und anhand dieser erläutert, als Speicherkapazitäten C von zwei Speicherzellen MC: Gemäß FIG 4 ist oberhalb der gemeinsamen Elektrode C1 zunächst eine dritte Isolierschicht IS3 angeordnet und anschließend an diese ein elektrisch leitendes Material. Letzteres dient als gemeinsames Gate G für die noch zu beschreibenden Auswahltransistoren T der Speicherzellen MC.

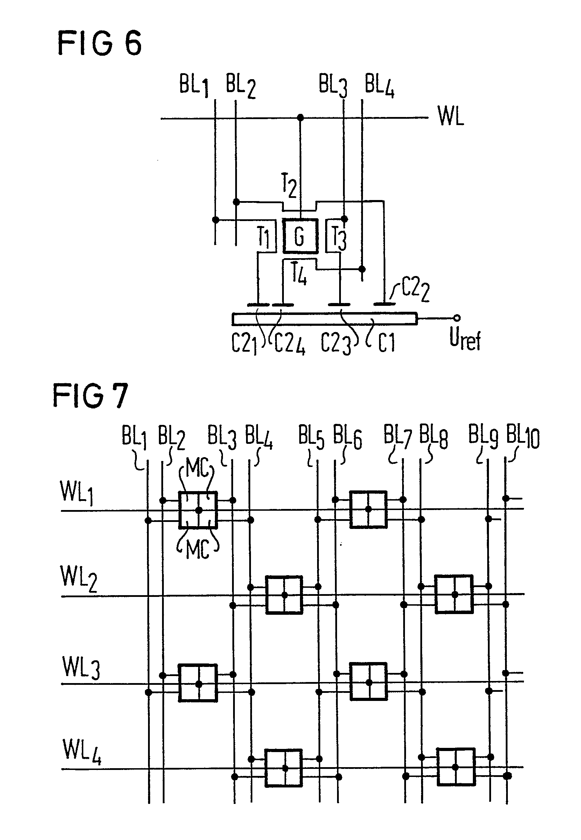

Am oberen Ende der Speicherelektroden C2 sind Bereiche ausgebildet, die durch die dritte Isolierschicht IS3 von dem gemeinsamen Gate G der Auswahltransistoren T isoliert sind und die den Auswahltransistoren T als Sourcebereiche S dienen. Oberhalb der Sourcebereiche S wiederum sind Kanalgebiete CH der Auswahltransistoren T angeordnet. Oberhalb der Kanalgebiete CH sind Gebiete angeordnet, die den Auswahltransistoren T als Drain D dienen und die, wie allgemein üblich, mit Bitleitungen BL verbunden sind. Letztere sind hier, der besseren Unterscheidung halber, mit $BL_1$ und $BL_2$ bezeichnet. Die in Klammern gesetzten Bezugszeichen $BL_3$ und $BL_4$ entfallen, soweit FIG 4 in Verbindung mit den FIG 1 und 2 betrachtet wird; sie sind jedoch relevant bezüglich einer Betrachtung hinsichtlich der FIG 3 und 5.

Die Ausführungsform nach den FIG 1 und 4 umfaßt also ein Paar dynamischer 1-Transistor-Speicherzellen MC in einer grabenförmigen Vertiefung Gr eines Substratbereiches B. Jede Speicherzelle MC des Paares von Speicherzellen enthält einen Auswahltransistor T und eine Speicherkapazität C, wobei die Auswahltransistoren T vertikal oberhalb der Speicherkapazitäten C angeordnet sind. Besonders vorteilhaft ist dabei, daß sich die Speicherzellen MC jedes Speicherzellenpaares bei ihren Auswahltransistoren T das Gate G gemeinsam teilen und daß sie sich bei ihren Speicherkapazitäten C die gemeinsame Elektrode C1 gemeinsam teilen. Dies spart, in Draufsicht betrachtet, d.h. lateral, gegenüber dem gattungsgemäßen Speicherzellenkonzept sehr viel Platz. Dadurch, daß die Speicherkapazitäten C unterhalb der Auswahltransistoren T angeordnet sind, ist die Softfehlerempfindlichkeit gegenüber EP-A 0 180 026 mindestens gleich gut und gegenüber DE-A 35 25 418 sogar besser, da die Speicherkapazitäten C durch die darüberliegenden Auswahltransistoren T vor Alpha-Strahlen geschützt sind.

Die gezeigten Ausführungsformen haben weiterhin den Vorteil, daß mögliche Leckstromverluste wesentlich geringer sind als beim Stand der Technik, da alle Speicherkapazitäten C wie auch die aktiven Gebiete der Auswahltransistoren T (Source S, Drain D, Gate G) elektrisch vollständig vom Substratbereich B isoliert sind. Ausführungsformen der vorliegenden Erfindung ohne diese vollständigen Isolierungen sind möglich; sie weisen jedoch nicht die genannten guten Leckstromeigenschaften auf.

Es ist auch günstig, die Vertiefungen Gr lochförmig auszugestalten zur Aufnahme des Paares von Speicherzellen MC. Weiterhin ist es vorteilhaft, die gemeinsamen Elektroden C1 von Speicherzellenpaaren MC entlang eines Paares BL1,BL2 von Bitleitungen als eine einzige allen diesen Speicherzellenpaaren gemeinsame Elektrode zu führen. Beim Verbinden der gemeinsamen Elektrode C1 mit einer bei Halbleiterspeichern üblichen Referenzspannung $U_{ref}$ als Bezugspotential der Speicherkapazitäten C dient dann die gemeinsame Elektrode C1 als Sammelschiene für die Referenzspannung $U_{ref}$.

Weiterhin ist es vorteilhaft, zwischen den Vertiefungen Gr und dem Substratbereich B (der durchaus auch eine Wanne bei üblicher CMOS-Technologie sein kann) Gebiete CH-STP vorzusehen vom gleichen Leitfähigkeitstyp wie der Substratbereich B, jedoch von gegenüber diesem höherer Dotierungskonzentration. Diese Gebiete dienen dann als sog. Channel-Stopper, so daß sich benachbarte Speicherzellenpaare nicht gegenseitig beeinflussen.

Der erfindungsgemäße Gegenstand läßt sich mit auf dem Gebiet integrierter Halbleiterschaltungen üblichen Mitteln herstellen: Im Substratbereich B werden die Vertiefungen Gr gebildet, vorzugsweise in Lochform. Möglich ist auch eine Grabenform. Daran kann sich die Bildung der genannten Channel-Stopper-Gebiete CH-STP anschließen. An den Seitenwänden und auf dem Grund der Vertiefungen Gr wird die zweite Isolierschicht IS2 gebildet. Auf diese zweite Isolierschicht IS2 wird dann entlang der Seitenwände der Vertiefungen Gr elektrisch leitfähiges Material gebracht. Nun werden zwischen zwei sich gegenüberliegende, mit dem elektrisch leitfähigen Material versehene Seitenwände der Vertiefungen Gräben geätzt parallel zum Verlauf der später aufzubringenden Bitleitungen BL, wobei sich diese Gräben über die jeweilige Vertiefung Gr hinaus erstrecken parallel zu den künftigen Bitleitungen BL, so daß alle Speicherzellen MC einer künftigen Bitleitung BL entlang eines Grabens angeordnet sind. Durch das Ätzen der Gräben wird in jeder Vertiefung Gr das auf die Seitenwände der Vertiefung Gr aufgebrachte elektrisch leitfähige Material so aufgetrennt, daß die beiden voneinander elektrisch getrennten Speicherelektroden C2 des Paares von Speicherzellen MC entstehen.

Nun wird auf die Speicherelektroden C2 und die restlichen Seitenwände der Gräben die erste Isolierschicht IS1 aufgebracht. Daran schließt sich ein teilweises Auffüllen der Gräben sowohl innerhalb wie auch außerhalb der Vertiefungen Gr mit elektrisch leitfähigem Material an. Dadurch entsteht die gemeinsame Elektrode C1. Diese ist ja sowohl dem Paar von Speicherzellen MC innerhalb einer Vertiefung Gr gemeinsam wie auch allen Speicherzellen MC entlang einer Bitleitung BL. Die Höhe des Auffüllens ist aus FIG 4 ersichtlich (in etwa Oberkante der gemeinsamen Elektrode C1). Anschließend werden diejenigen Bereiche der ersten Isolierschicht IS1, die sich, im Querschnitt betrachtet, innerhalb einer Vertiefung Gr oberhalb des oberen Endes der gemeinsamen Elektrode C1 befinden, entfernt. Diejenigen Teile der Speicherelektrode C2, die ebenfalls oberhalb des oberen Endes der gemeinsamen Elektrode C1 angeordnet sind, werden nun entweder entfernt und in Form halbleitenden Materials geeigneter Dotierung unter Bildung der Kanalgebiete CH und der Sourcegebiete S der Auswahltransistoren T neu aufgebracht, oder sie werden, falls dies technisch möglich ist (z.B. dann, wenn die Speicherelektroden C2 im wesentlichen polykristallines Silizium enthalten) in halbleitendes Material (z.B. einkristallines Silizium) umgewandelt unter Bildung der vorgenannten Source- und Kanalgebiete S,CH. Oberhalb der Kanalgebiete CH werden dann die Draingebiete D der Auswahltransistoren T gebildet, wobei diese gleichzeitig Bestandteile der Bitleitungen BL (bzw. BL1,BL2) sein können. Auf die gemeinsame Elektrode C1 sowie auf die Source-, Drain- und Kanalgebiete S,D,CH der Auswahltransistoren T wird jetzt die dritte Isolierschicht IS3 aufgebracht. In den verbleibenden Raum der Vertiefungen Gr, d.h. auf die dritte Isolierschicht oberhalb der gemeinsamen Elektrode C1 und zwischen die dritten Isolierschichten IS3 der beiden Auswahltransistoren T wird wiederum elektrisch leitendes Material aufgebracht. Dieses dient den beiden Auswahltransistoren T jeder Vertiefung Gr als gemeinsames Gate G. Die dritten Isolierschichten IS3 dienen somit einerseits zur gegenseitigen Isolation von gemeinsamer Elektrode C1 und gemeinsamem Gate G jeder Vertiefung Gr und andererseits als Gateoxide bezüglich der Auswahltransistoren T. Das Gate G wird später mit der noch aufzutragenden Wortleitung WL verbunden.

·Beiden Ausführungsformen nach den FIG 1 und 2, die prinzipiell gleich aufgebaut sind, und die sich lediglich in der geometrischen Form der Speicherelektroden C2 voneinander unterscheiden, wie bei einem Vergleich der beiden FIG ersichtlich, sind zwei Speicherelektroden C2 seitlich von und parallel zu zwei zueinander parallelen Hauptflächen der gemeinsamen Elektrode Cl angeordnet. Demgegenüber weist die Ausführungsform nach FIG 3 vier Speicherelektroden C2 auf. Damit läßt sich innerhalb einer einzigen Vertiefung Gr ein Quartett von vier Speicherzellen MC realisieren. Jedes Quartett von vier Speicherzellen MC teilt sich eine gemeinsame Elektrode C1 und ein gemeinsames Gate G. FIG 3 zeigt die Kondensatoren-Anordnung in Draufsicht. Die FIG 4 und 5 zeigen je einen Querschnitt durch ein erfindungsgemäßes Quartett von Speicherzellen MC. Die bei den FIG 4 und 5 gewählten Schnittebenen stehen senkrecht aufeinander. Ein Quartett von Speicherzellen MC ist, wie leicht einsehbar, an ein Quartett $BL\cdot, BL_2, BL_3, BL_4$ von Bitleitungen BL angeschlossen. Dies ist in den FIG 4,5 angedeutet. Ein entsprechender Halbleiterspeicher läßt sich analog den obigen Ausführungen zu den FIG 1 und 2 herstellen. Die gemeinsame Elektrode C1 bedarf bei der Herstellung jedoch besonderer Aufmerksamkeit: Wegen der beiden gegenüber den FIG 1,2 zusätzlichen Speicherelektroden C2 des dritten und vierten Auswahltransistors T jedes Quartetts von Speicherzellen MC reicht die gemeinsame Elektrode C1 in jeder Vertiefung Gr vorteilhafterweise soweit nach unten, daß eine Weiterführung in Richtung der Bitleitungen BL unterhalb der Speicherelektroden C2 des dritten und vierten Auswahltransistors T des Speicherzellen-Quartetts bis zur entsprechend benachbarten Vertiefung Gr möglich ist. Innerhalb jeder Vertiefung Gr muß die gemeinsame Elektrode C1 jedoch soweit nach oben reichen, daß sichere Kondensatorfunktionen mit den Speicherelektroden C2 gewährleistet sind. Betrachtet man die so ausgestaltete gemeinsame Elektrode C1 mehrerer Vertiefungen Gr entlang einer Bitleitung BL, d.h. in der Querschnittsebene nach FIG 5, so stellt man fest, daß sie ein kammartiges Aussehen hat, wobei die den Zinken des Kammes entsprechenden Teile innerhalb der Vertiefungen Gr angeordnet sind.

FIG 6 zeigt eine schematische, schaltplanmäßige Darstellung eines Quartetts von Speicherzellen MC mit gemeinsamen Gate G, gemeinsamer Elektrode C1, einer Wortleitung WL, den vier Auswahltransistoren T1 bis T4, den vier Speicherelektroden $C2_1$ bis $C2_4$, der vier Speicherkapazitäten C und den vier Bitleitungen $BL_1$ bis $BL_4$.

In FIG 7 ist in einem größeren Ausschnitt aus einem erfindungsgemäßen Halbleiterspeicher dessen Architektur prinzipiell dargestellt unter Verwendung von Quartetten von Speicherzellen MC. Die Bitleitungen BL und die Wortleitungen WL sind der Übersichtlichkeit halber durchnumeriert.

Ein wesentlicher Vorteil der vorliegenden Erfindung ist auch, daß bei vorgegebener Gesamtzahl von Speicherzellen MC des Halbleiterspeichers die Anzahl der notwendigen Kontakte für Wortleitungen WL indirekt proportional ist der Anzahl von Speicherzellen MC je Vertiefung Gr.

## Ansprüche

1. Integrierter Halbleiterspeicher mit entlang von Wort- (WL) und Bitleitungen (BL) matrixförmig angeordneten 1-Transistor-Speicherzellen (MC), die jede einen Auswahltransistor (T) und eine Speicherkapazität (C) enthalten, wobei der Auswahltransistor (T) und die Speicherkapazität (C) übereinander in einer Vertiefung (Gr) eines Substratbereiches (B) angeordnet sind und wobei der Auswahltransistor (T) vertikal im Bereich der Vertiefung (Gr) angeordnet ist, **dadurch gekennzeichnet,** daß innerhalb einer Vertiefung (Gr) wenigstens zwei 1-Transistor-Speicherzellen (MC) vorgesehen sind mit jeweils einem gemeinsamen Gate (G) der Auswahltransistoren (T) und jeweils einer gemeinsamen Kondensatorelektrode (C1) der Speicherkapazitäten (C).

2. Integrierter Halbleiterspeicher nach Anspruch 1, **dadurch gekennzeichnet,** daß die Vertiefungen (Gr) grabenförmig sind.

3. Integrierter Halbleiterspeicher nach Anspruch 1, **dadurch gekennzeichnet,** daß die Vertiefungen (Gr) lochförmig sind.

4. Integrierter Halbleiterspeicher nach einem der vorhergehenden Ansprüche, **dadurch gekennzeichnet,** daß die gemeinsame Kondensatorelektrode (C1) allen Speicherzellen (MC) entlang wenigstens einer Bitleitung (BL) gemeinsam ist.

5. Integrierter Halbleiterspeicher nach Anspruch 4, **dadurch gekennzeichnet,** daß die gemeinsame Kondensatorelektrode (C1), im Längsschnitt betrachtet, kammförmig ausgebildet ist.

6. Integrierter Halbleiterspeicher nach einem der vorhergehenden Ansprüche, **dadurch gekennzeichnet,** daß zwischen den Speicherzellen (MC) und dem Substratbereich (B) Gebiete (CH-STP) vorgesehen sind vom gleichen Leitfähigkeitstyp wie der Substratbereich (B), jedoch mit höherer Dotierungskonzentration als der Substratbereich (B).

FIG 1

FIG 2

FIG 3

FIG 4

FIG 5

## FIG 6

## FIG 7

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | PATENT ABSTRACTS OF JAPAN, Vol 12, No 397 (E-672)[3244] Oktober 21, 1988 ; & JP-A-63 140 565 (MITSUBISHI 13/6/88) * Zusammenfassung; figuren * | 1-4 | G 11 C 11/24 H 01 L 27/108 |
| A | IDEM --- | 5,6 | |
| Y | IBM TECHNICAL DISCLOSURE BULLETIN, Vol 29, No 5, Oktober 1986, Seiten 2335-2340, IBM Corp., New York, USA: "High Density Vertical DRAM Cell" * Seite 2335, Zeile 1 - Seite 2336, Zeile 4; Figuren 1,3 * | 1-4 | |
| A | IDEM --- | 5,6 | |
| Y | US-A-4 673 962  (Chatterjee et al.) * Spalte 4, Zeile 36 - Spalte 5, Zeile 4; Spalte 6, Zeile 57 - Spalte 7, Zeile 6; Figuren 3,12 * | 1-4 | |
| A | | 5,6 | RECHERCHIERTE SACHGEBIETE (Int. Cl.5) |
| A | EP-A-0 180 026  (Texas) * Seite 10, Zeile 1 - Seite 11, Zeile 21; Figur 2 * --- | 1-6 | G 11 C 11/00 H 01 L 27/00 |
| A | PATENT ABSTRACTS OF JAPAN, Vol 13, No 26 (E-706)[3374] January 20, 1989; & JP-A-63 229 745 (FUJITSU 26/9/88) * Zusammenfassung, Figur * --- | 1-6 | |
| A | PATENT ABSTRACTS OF JAPAN, Vol 13, No 325 (E-792)[3673] July 21, 1989; & JP-A-01 91 447 (MATSUSHITA 11/4/89) * Zusammenfassung, Figur * ---                          -/- | 1-6 | |

Der vorliegende Recherchenbericht wurde für alle Patentansprüche erstellt

| Recherchenort | Abschlußdatum der Recherche | Prüfer |
|---|---|---|
| DEN HAAG | 06-02-1990 | GEOGHEGAN C.H.B. |

EPO FORM 1503 03.82 (P0403)

Europäisches
Patentamt

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | PATENT ABSTRACTS OF JAPAN, Vol 11, No 220 (E-524) July 16, 1987; & JP-A-62 039 053 (NEC 20/2/87) * Zusammenfassung, Figur * ----- | 1-6 | |
| | | | **RECHERCHIERTE SACHGEBIETE (Int. Cl.5)** |

Der vorliegende Recherchenbericht wurde für alle Patentansprüche erstellt

| Recherchenort | Abschlußdatum der Recherche | Prüfer |
|---|---|---|
| DEN HAAG | 06-02-1990 | GEOGHEGAN C.H.B. |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument
........................................................................
& : Mitglied der gleichen Patentfamilie, übereinstimmendes
    Dokument

EPO FORM 1503 03.82 (P0403)